# EUROPEAN PATENT SPECIFICATION

(11) **EP 0 354 372 B1**
(45) Date of publication and mention of the grant of the patent: **06.04.1994**
(21) Application number: 89112789.6
(22) Date of filing: 12.07.1989
(51) Int. Cl.: H01L 27/12, H01L 29/784, H01L 29/808

(54) **Plurality of thin film field-effect transistors and method of manufacturing the same**
Mehrzahl von Dünnfilmfeldeffekttransistoren und Verfahren zu ihrer Herstellung
Pluralité de transistors à effet de champ en couche mince et procédé pour sa fabrication

(30) Priority: 19.07.1988 JP 180575/88
(43) Date of publication of application: 14.02.1990
(73) Proprietor: AGENCY OF INDUSTRIAL SCIENCE AND TECHNOLOGY, Chiyoda-ku Tokyo 100 (JP)
(72) Inventor: Hayashi, Yutaka Electrotech. Lab. Agency of, Tsukuba-shi Ibaraki-ken 305 (JP); Yamanaka, Mitsuyuki Electrotech. Lab. Agency of, Tsukuba-shi Ibaraki-ken 305 (JP); Yoshimi, Takashi, Taito-ku Tokyo 110 (JP)
(74) Representative: Goddar, Heinz J., Dr.

(56) References cited:
- US-A- 4 700 461
- IEEE ELECTRON DEVICE LETTERS, vol. EDL-3, no. 7, July 1982, pages 187-189, IEEE, New York, US; T. KODAMA et al.: "A self-alignment process for amorphous silicon thin film transistors"
- PATENT ABSTRACTS OF JAPAN, vol. 9, no. 284 (E-357)[2007], 12th November 1985; & JP-A-60 124 975
- JAPANESE JOURNAL OF APPLIED PHYSICS, vol. 25, no. 9, part 2, September 1986, pages L755-L757, Tokyo, JP; H. OKADA et al.: "Fully self-aligned amorphous-silicon MOS transistors"
- PATENT ABSTRACTS OF JAPAN, vol. 12, no. 246 (E-632)[3093], 12th July 1988; & JP-A-63 34 978

## Description

The present invention relates to a plurality of thin film field-effect transistors and a method of manufacturing the same and, more specifically, to a plurality of insulated gate field-effect transistors having a gate electrode capacity-coupled with a semiconductor channel through a gate insulating layer or to a plurality of junction-gate field-effect transistors having a gate layer joined to a semiconductor channel layer, and to a method of manufacturing such a plurality of field-effect transistor.

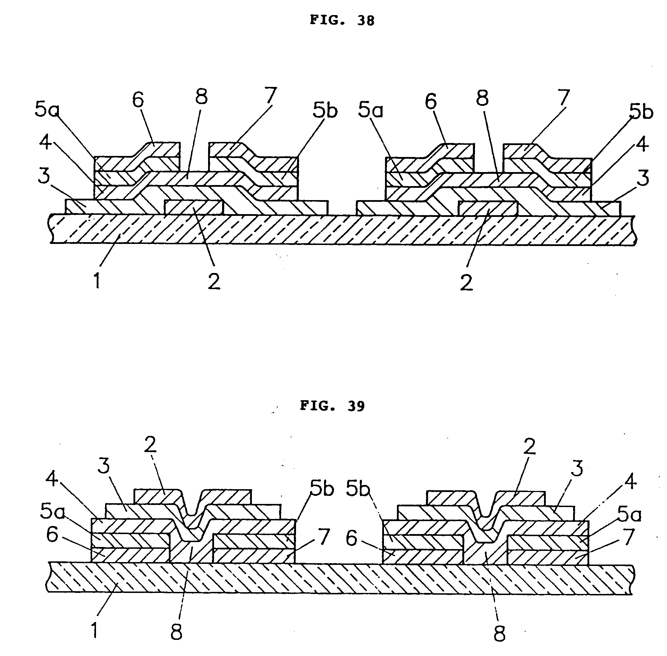

The construction of conventional field-effect transistors will be described in an example of an insulated gate field effect transistor with reference to Figs. 38 and 39. In an insulated gate field effect transistor, a source electrode 6 and a drain electrode 7 are joined respectively through second thin semiconductor layers 5a and 5b formed of doped thin film semiconductor to a first semiconductor layer 4. A gate electrode 2 is capacity-coupled through the gate insulating layer 3 with a channel 8 of the first semiconductor layer 4 between the source electrode 6 and the drain electrode 7.

The construction will be described with reference to concrete example shown in Fig. 38 which typically shows a plurality of insulated gate field effect transistors each of which having a gate electrode 2 formed on a substrate 1. In the same figure, a conductive layer as a gate electrode 2 is formed on the substrate 1 and covered by a gate insulating layer 3, then a first semiconductor layer 4 formed of a thin silicon film, and second semiconductor layers 5a, 5b formed of doped thin silicon films are deposited in order on the gate insulating layer 3, then conductive metal layers composed of a source electrode 6 and a drain electrode 7 are seperately formed on the second semiconductor layers 5a, 5b. A gap between the source electrode 6 and the drain electrode 7 is formed opposite to the gate electrode 2. A portion between the second semiconductor layers 5a, 5b corresponding to the gap is removed by etching, and a portion of the first semiconductor layer 4 corresponding to the gap forms a channel 8.

Fig. 39 shows construction in which the electrodes and semiconductor layers are formed on a substrate in the reverse order to the above-mentioned one. That is, formed on a conductive layer are a source electrode 6 and a drain electrode 7, and then formed on the source electrode 6 and the drain electrode 7 are doped second semiconductor layers 5a, 5b. A first semiconductor layer 4 and an insulating layer 3 are deposited in order on the layers 5a and 5b, then a conductive metal layer of a gate electrode 2 is deposited in order opposite to the gap between the source electrode 6 and the drain electrode 7. There is formed a channel 8 in the gap portion of the first semiconductor layer 4 between the source electrode 6 and the drain electrode 7, namely, a portion removing the second semiconductor layers 5a, 5b.

The gate threshold voltage Vₜₕ of the transistor having such a construction is determined by a work function of the conductive material forming the gate electrode 2, a charge density of the gate insulating layer 3, and an equivalent charge level density N_{E} of the first semiconductor layer 4 forming the channel 8.

In constructing an electronic circuit on a substrate by forming thin semiconductor films on the substrate by a plasma CVD process or a molecular beam epitaxy process, transistors respectively having similar film constructions are formed simultaneously on the substrate under the same film forming conditions deciding the foregoing requirements. Accordingly, the transistors have the same gate threshold voltage Vₜₕ.

In most cases, it is required to set a predetermined gate threshold voltage Vₜₕ accurately for such a thin film field effect transistor in accordance with the purpose of desining of an electronic circuit. On the other hand, since changing the material for forming the films, the film forming process or film forming conditions are only a means of adjusting the gate threshold voltage Vₜₕ, the foregoing manufacturing conditions must be changed to construct field effect transistors respectively having different gate threshold voltages. However, from the viewpoint of process management, it is difficult to change the manufacturing conditions at any time and, in view of productivity, it is desirable to maintain the same manufacturing conditions. Furthermore, even if the manufacturing conditions could be changed, practically it is impossible to regulate optionally the work function of the conductive material for forming the gate electrode 2, the charge density of the gate insulating layer 3 and the equivalent charge level density N_{E} of the first semiconductor layer 4 in which the channel 8 is formed. Thus, the accurate determination of the gate threshold voltage Vₜₕ has been very difficult.

Where it is required, in accordance with a requirement for designing of the electric circuit, to form a plurality of thin film field effect transistors respectively having different gate threshold voltages on a same substrate, it is impossible to meet such a requirement, because the thin film field effect transistors are formed on the same substrate by using the same materials and under the same film forming conditions.

In view of the problems of the prior art, it is a first object of the present invention to provide a plurality of thin film transistors capable of solving the foregoing problems.

It is a second object of the present invention to provide a method for readily manufacturing said plurality of thin film field effect transistors in the foregoing object of the invention.

These objectives are achieved by a plurality of thin film field-effect transistors and a manufacturing method thereof as set out in the appended set of claims
The second semiconductor layers 5a and 5b already disclosed in connection with Figs. 38 and 39 are formed between the source electrode 6 and the drain electrode 7 and the first semiconductor layer 4 to make the electrodes 6, 7 contact the first semiconductor layer 4 in an ohmic contact. The inventors of the present invention found that the gate threshold voltage Vₜₕ can be increased or decreased by leaving a portion between the second semiconductor layers 5a and 5b in the channel 8 between the source electrode 6 and the drain electrode 7 or by forming a doped third semiconductor film, i.e., the intermediate semiconductor layer 9, on the same portion of the second semiconductor layer 5a and 5b and that there is a correlation between the thickness of the intermediate semiconductor layer 9 and the gate threshold voltage Vₜₕ.

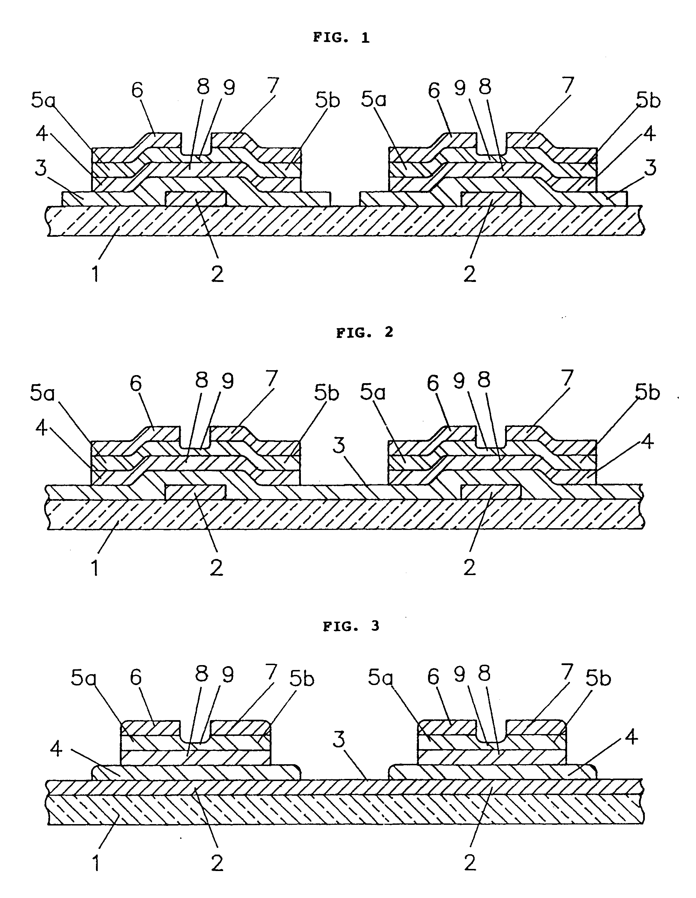

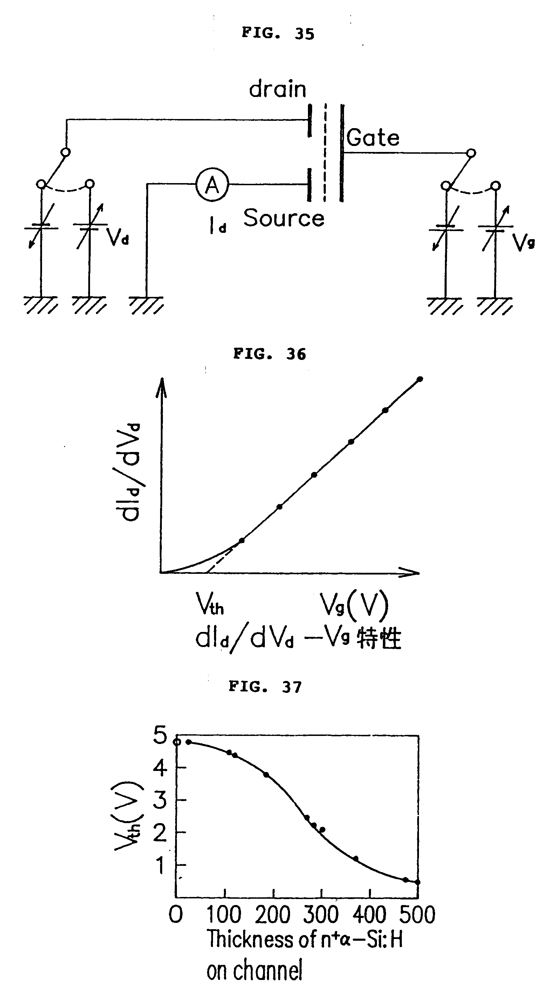

For example, in an example as shown in Fig. 37 as described later shows that, a doped n-type amorphous silicon layer is used as the second semiconductor layers 5a and 5b, and there is formed on the gap portion between the source electrode 6 and the drain electrode 7 an intermediate semiconductor 9 in the manner shown in Fig. 1, and the gate threshold voltage Vₜₕ will be changed when the thickniss of the layer 9 varies. Accordingly, by forming the intermediate semiconductor layer 9 between the source electrode 6 and drain electrode 7, and controlling the thickness of the layer 9, it is possible to vary the gate threshold voltage Vₜₕ of the field effect transistors formed on the same substrate where necessary. In an embodiment of the invention, this is achieved by partly etching said layer 9 since during etching the middle portion of the second semiconductor layers 5a, 5b are remained partly or wholly to be used as the intermediate semiconductor layer 9, it is possible to manufacture the layer 9 and to control the thickness of the layer 9 with ease. Accordingly, the thin film field effect transistors having arbtitrary gate threshold voltage Vₜₕ can be obtained.

In addition, it is possible by means of other film-forming process instead of the etching process, to form in the middle portion of the second semiconductors 5a and 5b the doped third semiconductor layer 10 used as the intermediate semiconductor layer 9 whereby the thin film field effect transistors having arbitrary gate threshold voltage Vₜₕ can be obtained as well.

Furthermore, if using p-type semiconductor layer is used as an intermediate layer 9 instead of using n-type semiconductor layer shown in Fig. 37, the characteristic relationship between the thickness of layer 9 and the gate threshold voltage Vₜₕ is reverse to the characteristic shown in Fig. 37. This is applied to the case the conductivity type of the impurity contained in the second semiconductor layers 5a, 5b and the impurity in the intermediate semiconductor layer 9 are differentiated from each other, namely, the relationship between the thickniss of the intermediate semiconductor layer 9 and the gate threshold voltage Vₜₕ is characterized in accordance with the conductivity type of the impurity contained in the intermediate semiconductor layer 9.

These functions are made absolutely same both in an insulating gate type field effect transistor having gate electrode 2 joined to the first semicondutor layer 4 through the gate insulating layer 3 and in a junction-gate type field effect transistor having gate layer 2 forming barrier together with the channel 8 and joined to the first semiconductor layer 4.

A thin film field-effect transistor having a doped semiconductor layer formed in contact with the channel on the substrate side thereof is known from US-A-4 700 461. A plurality of said transistors is further disclosed in that document.

A thin film field-effect transistor provided with a semiconductor layer formed in contact with a channel layer on the side thereof which is opposite to the substrate side is known from IEEE Electron Device Letters, Vol. EDL-3, No. 7, July 1982, pages 187-189.
In Figs. 1-6, 18, 21-23, 32, examples of pluralities of transistors which are not part of the present invention are shown, for a better understanding thereof.
In Figs. 7-17, 19, 20, 24-31, 33, 34, essential constructions of pluralities of thin film field effect transistors according to the present invention have been shown, based on which the embodiments of the present invention will be described in detail.
Fig. 35 is a circuit diagram of an electric circuit for measuring the gate threshold voltages of the thin film field effect transistors of Figs. 1 to 34;
Fig. 36 is a graph showing an example of dI_{d}/dV_{d}-to-V_{g} characteristic measured by the electric circuit of Fig. 35;
Fig. 37 is a graph showing an example of the relation between the gate threshold voltage and the thickness of an intermediate semiconductor layer; and
Figs. 38 and 39 are schematic sectional views showing the multilayer structures of conventional thin film field effect transistors.

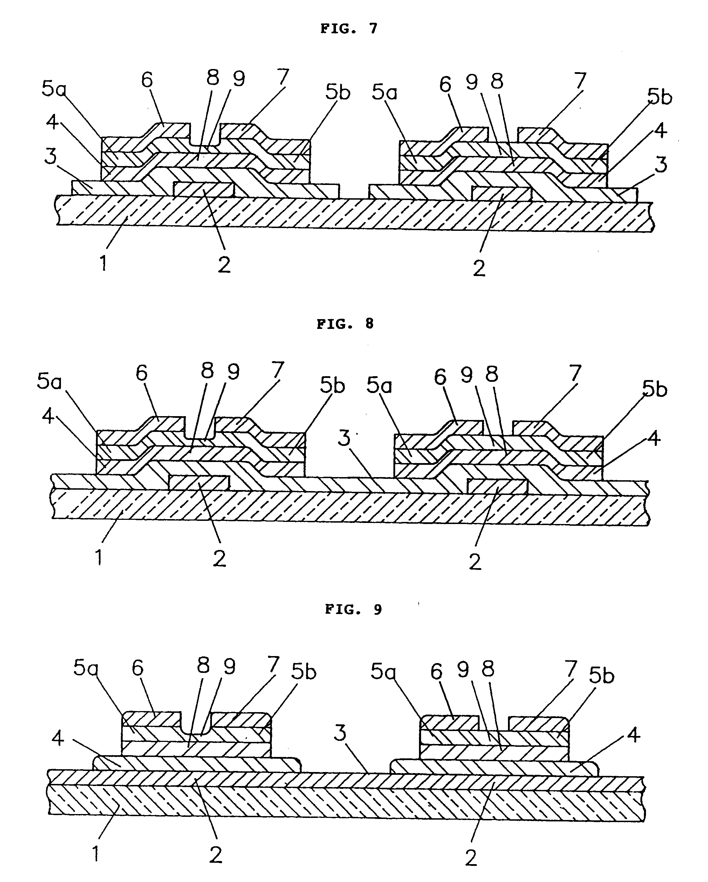

First, in Figs. 1 and 7, formed on a substrate 1 are a conductive layer as a gate electrode 2 covered by a gate insulating layer 3, a first semiconductor layer of a thin silicon film 4 and second semiconductor layers of doped thin silicon film 5a, 5b in order sequentially formed on the gate insulating layer 3, and conductive layers of metal and the like of a source electrode 6 and a drain electrode 7 seperatly formed thereon. A gap between the source electrode 6 and the drain electrode 7 is positioned opposite the gate electrode 2. A portion of the second semiconductor layer 5 corresponding to the gap is etched partly to form seperated portions 5a and 5b. However in this case, a portion between the second semiconductor layers 5a and 5b is remained partly to form an intermediate semiconductor layer 9. Alternatively, the portion between layers 5a and 5b can not be etched to form the intermediate semiconductor layer 9 wholly, therefore, a portion of the first semiconductor layer 4 in contact with the intermediate semiconductor layer 9 forms a channel 8.

The pluralities of transistors shown in Figs. 2 and 8 are basically the same as those shown in Figs. 1 and 7. In said pluralities of transistors, gate electrodes 2 are formed as film on the substrate 1, then the gate insulating layer 3 is formed on the substrate 1 so as to be used in common to a plurality of transistors.

The pluralities of transistors shown in Figs. 3 and 9 are basically the same as those shown in Figs. 1 and 7. In said pluralities of transistors a gate electrode 2 is formed on the substrate 1 as a conductive film in common to a plurality of transistors. It is natural that a conductive film forming the gate electrode 2 and an insulating film 3 formed thereon may be used in common.

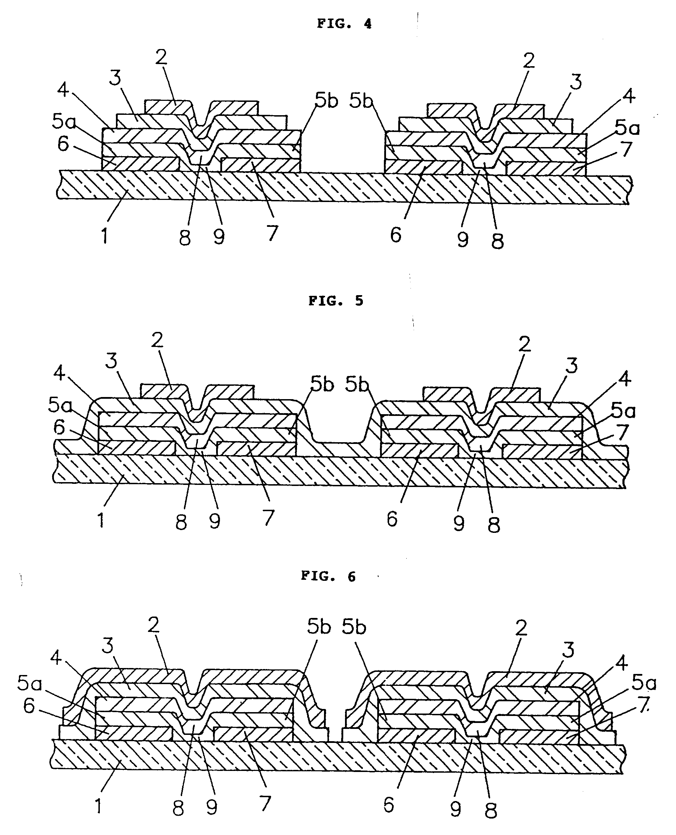

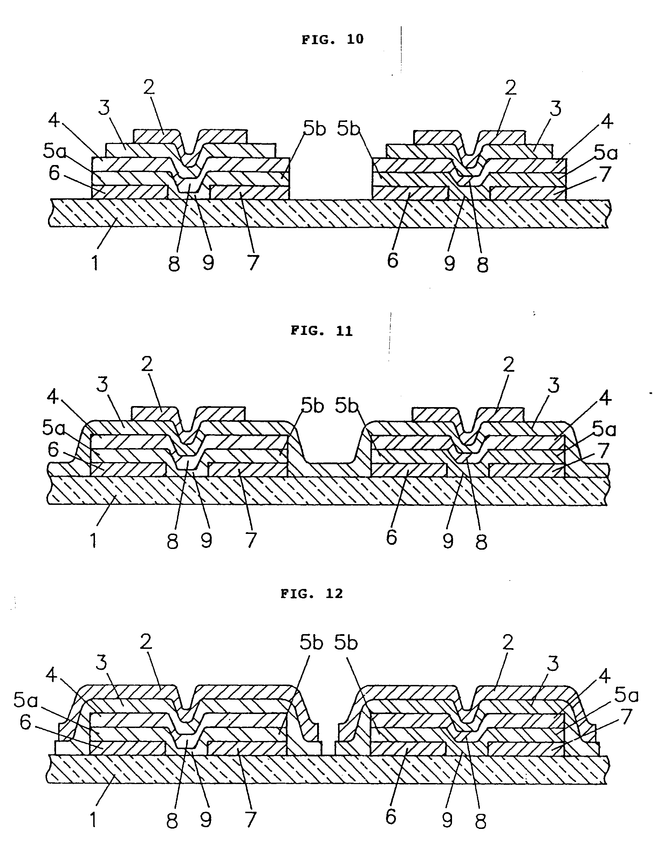

On the other hand, Figs. 4 and 10 show pluralities of transistors in which the deposited order of the electrode layer and the semiconductor layer are opposite to those set forth above. That is, after forming a source electrode 6 and a drain electrode 7 of conductive layers, doped second semiconductor layers 5a, 5b are formed on the source electrode 6 and the drain electrode 7. The second semiconductor layers 5a, 5b are formed as a film uniformly in a gap between the source electrode and the drain electrode 7, thereafter the gap is remained wholly as an intermediate semiconductor layer 9 or is removed partly by etching and remained partly to form an intermediate semiconductor layer 9. Furthermore, a first semiconductor layer 4 and an insulating layer 3 are deposited thereon sequentially and a conductive layer of metal forming a gate electrode 2 is sequentially deposited in that order opposite to the gap between the source electrode 6 and the drain electrode 7. A portion of the first semiconductor layer 4 corresponding to the gap between the source electrode 6 and the drain electrode 7, namely, a portion of the first semiconductor layer 4 in contact with the intermediate semiconductor layer 9 is a channel 8.

The pluralities of transistors shown in Figs. 5 and 11 are basically the same as those shown in Figs. 4 and 10. In said pluralities of transistors, a gate insulaing layer 3 is formed uniformaly on the substrate 1 after forming a source electrode 6, a drain electrode 7, a first semiconductor layer 4 and second semiconductor layers 5a, 5b respectively for using the gate insulating layer 3 in common to a plurality of transistors.

The pluralities of transistors shown in Figs. 6 and 12 are basically the same as those shown in Fig. 1. In said pluralities of transistors, a wide conductive film as the gate electrode 2 is formed on a gate insulating layer 3 which covers an area substantially corresponding to a first semiconductor layer 4 and second semiconductor layers 5a and 5b.

In the figures set forth above, two thin film field effect transistors are formed on the same substrate 1, namely, in the field effect transistors shown in Figs. 1 to 6, the thickness of both the intermediate semiconductor layer 9 are the same, while in each of Figs. 7 to 12, the thickness of each intermediate semiconductor layer 9 is differentiated from each other. In the latter pluralities of transistors, two thin film field effect transistor formed on the same substrate may be differentiated from each other with respect to a gate threshold voltage Vₜₕ in accordance with the present invention.

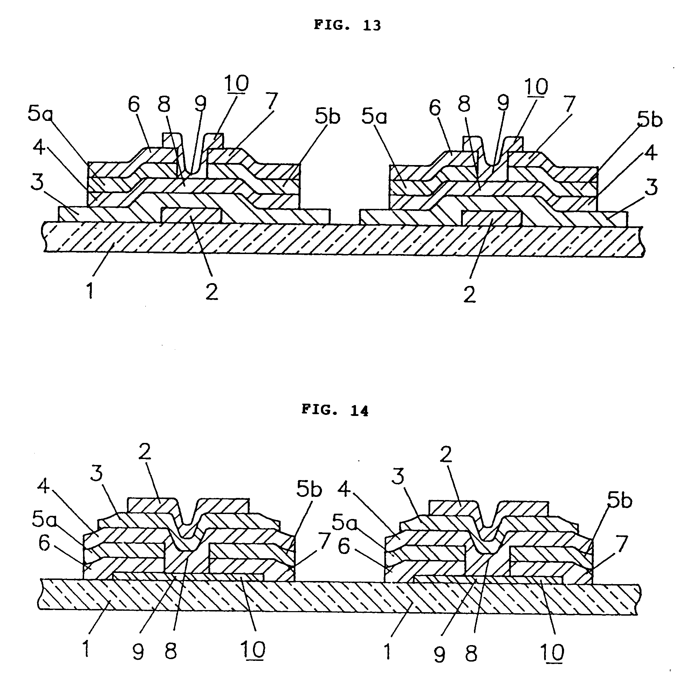

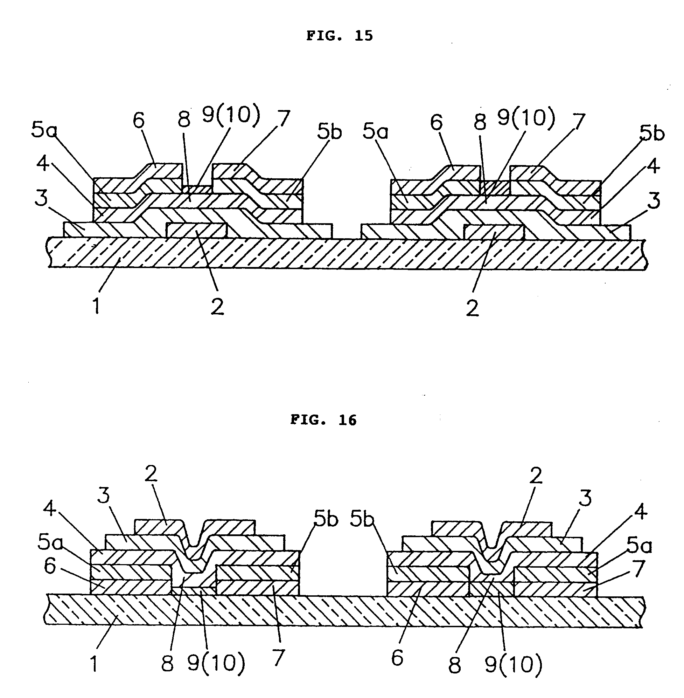

Figs. 13 and 16 show pluralities of transistors in which a doped third semiconductor layer 10 is formed in addition to second semiconductor layers 5a, 5b and a portion of the third semiconductor layer 10 in contact with a channel 8 forms an intermediate semiconductor layer 9. Among them, in the embodiment of Figs. 13 and 15, the gate electrode 2 is formed on the lower layer side, namely on the side of substrate, but in the pluralities of transistors of Figs. 14 and 16 the third semiconductor layer 10 is deposited at the lower side of a source electrode 6 and a drain electrode 7.

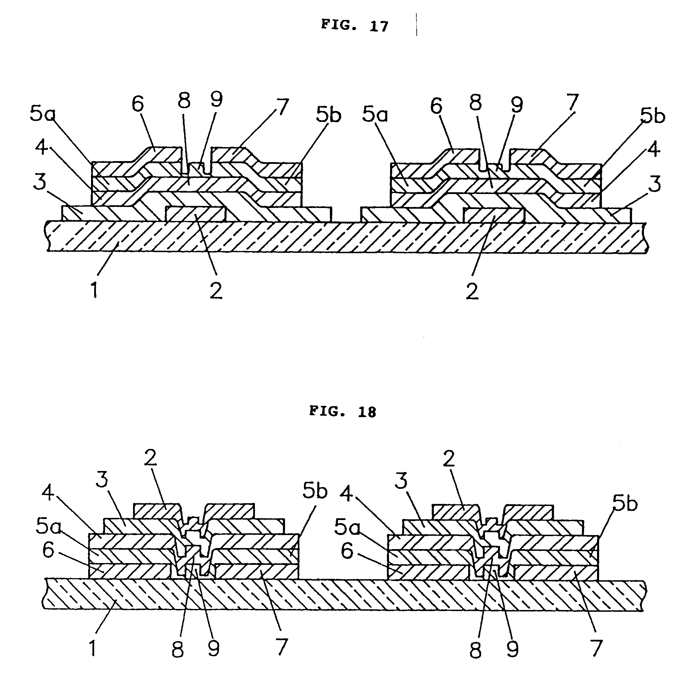

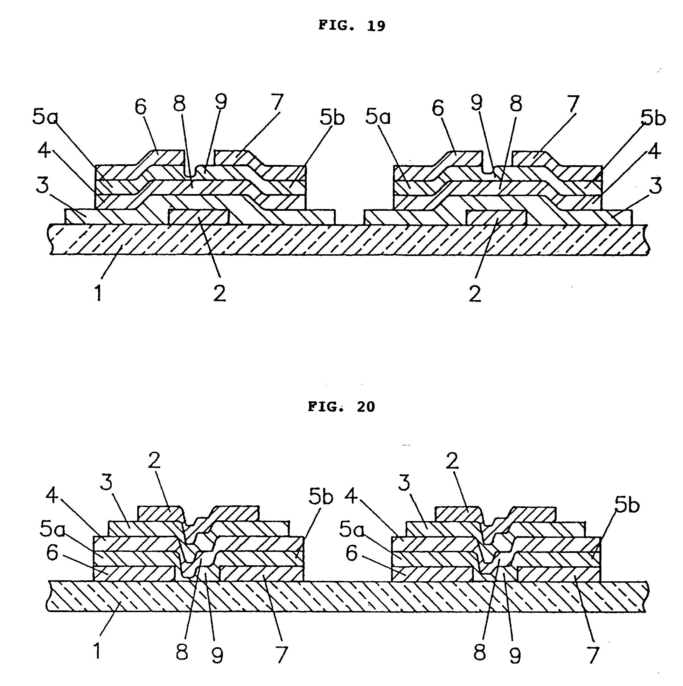

In the pluralities of transistors shown in Figs. 17 to 20, intermediate semiconductor layers 9 are etched partly or locally differentiated partially with respect to depths of etching so that the thickness of the intermediate semiconductor layers 9 differentiated from each other. In the pluralities of transistors shown in Figs. 17 and 18, the thickness of the central portion of the intermediate semiconductor layer 9 is greater than that of the side portions thereof. In the pluralities of transistors shown in Figs. 19 and 20, the thickness of one side portion of each intermediate semiconductor layer 9 is greater than that of the other side portion of the same. The respective sectional shapes of the intermediate semiconductor layers 9 are substantially uniform throughout the length along the longitudinal direction of channels 8. The thickness of the intermediate semiconductor layer 9 need not be uniform with respect to the direction of the width of the channel 8, but it is satisfactory if the portion of the intermediate semiconductor layer 9 has a predetermined thickness throughout the length along the longitudinal direction of the channel 8.

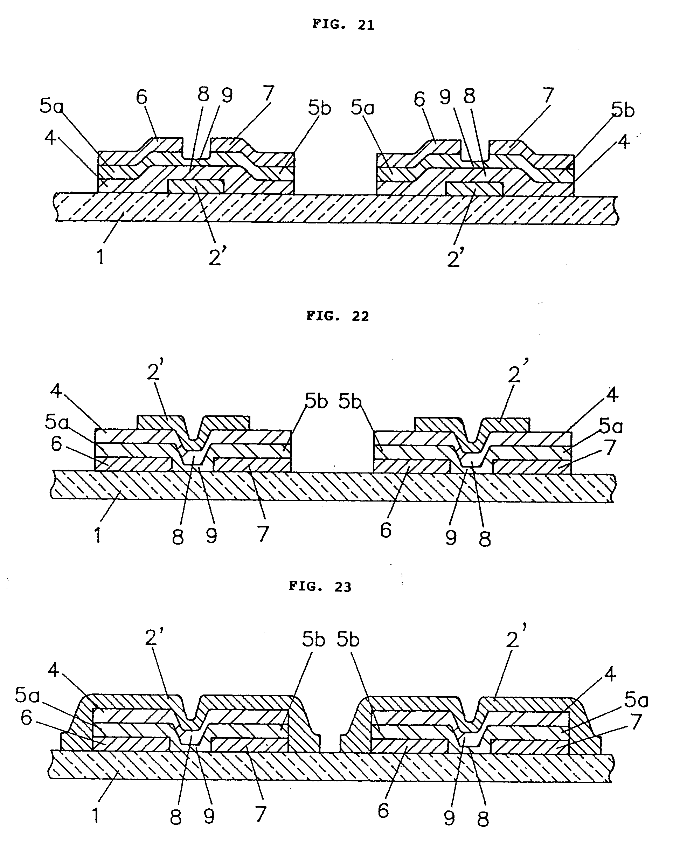

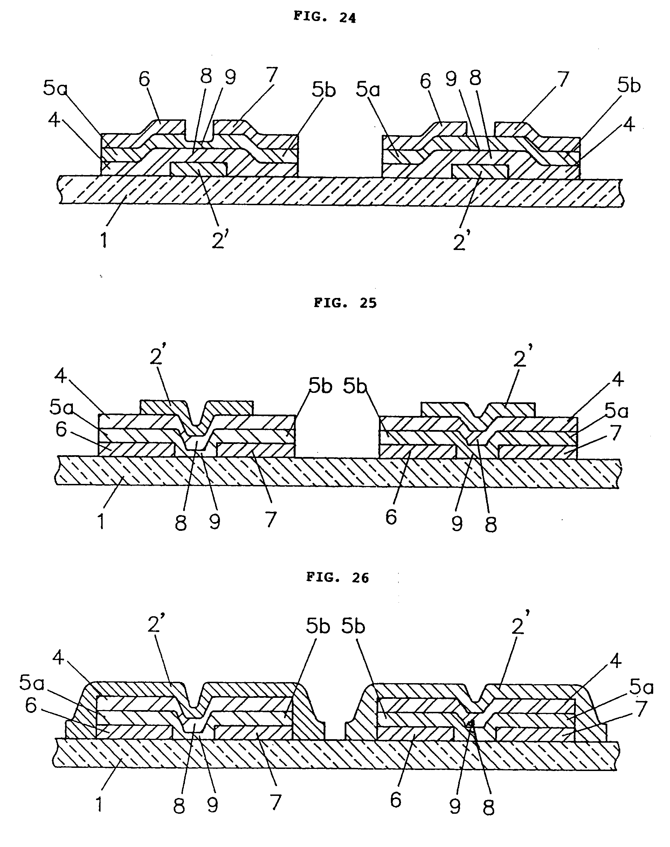

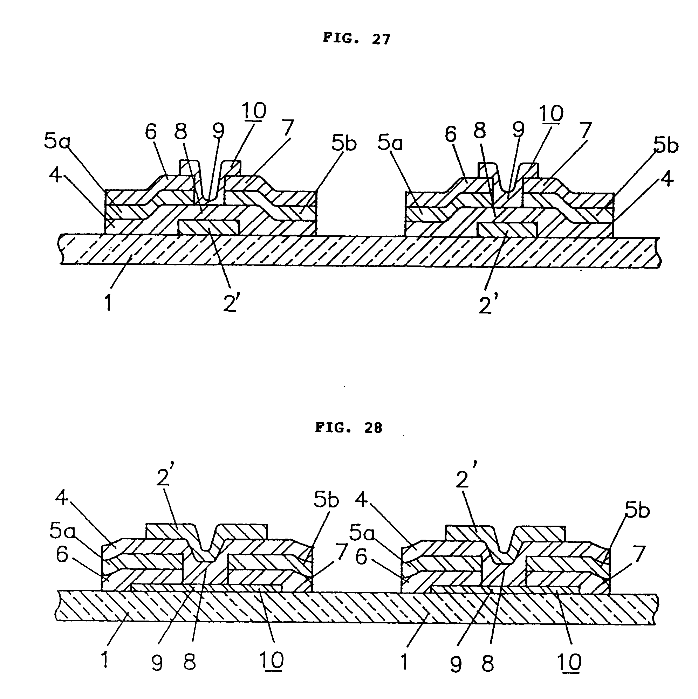

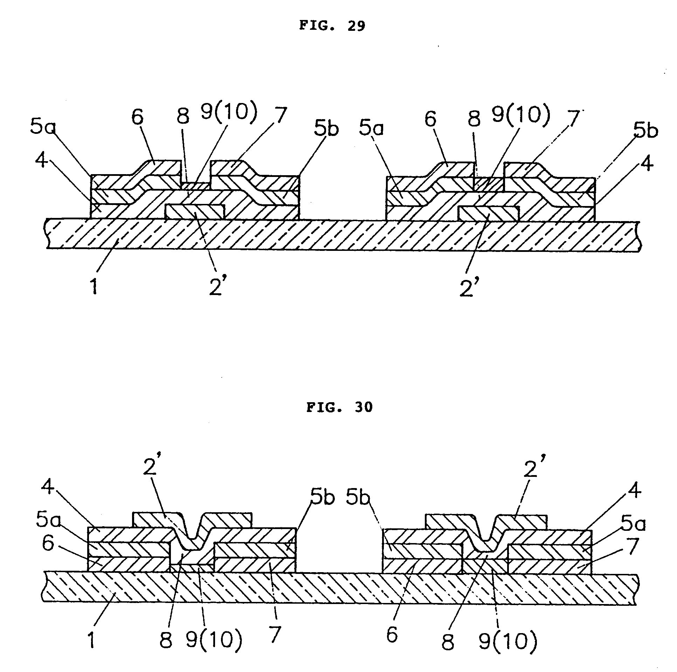

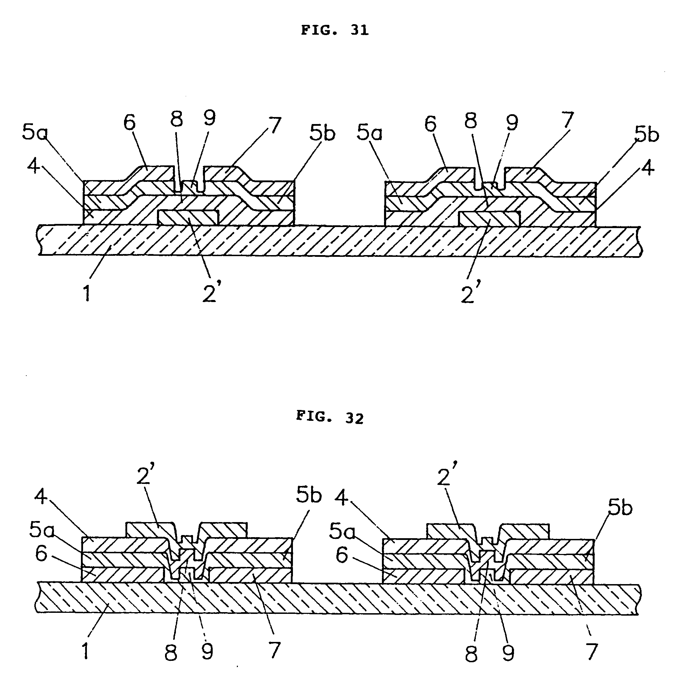

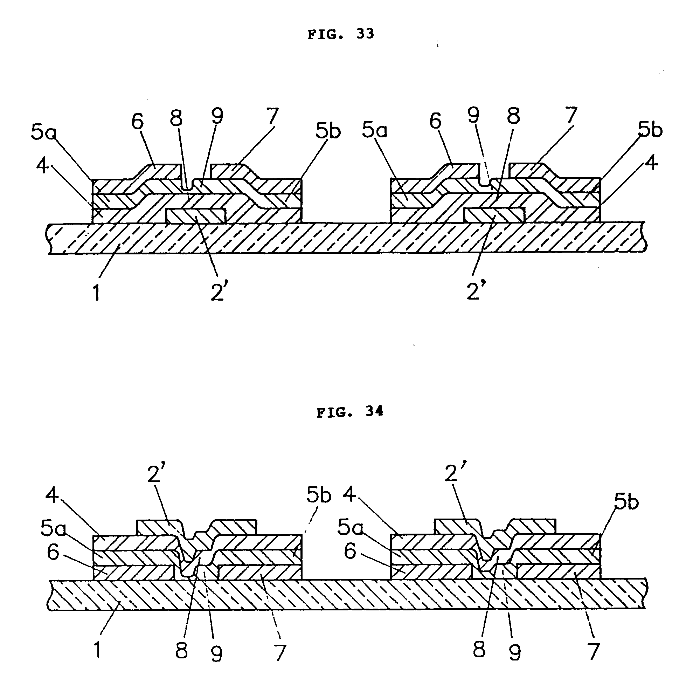

The pluralities of transistors shown in Fig. 1 to 20 relate to MIS field effect transistors having the gate electrode 2 joined through the gate insulating layer 3 to the first semiconductor layer 4. Shown in Fig. 21 to 36 are pluralities of junction field effect transistors, each transistor having a gate layer 2' directly jointed to a first semiconductor layer 4 without using any gate insulating layer 3. These pluralities of transistors are substantially the same in construction as those shown in Figs. 1 to 20, except that the junction field effect transistors shown in these embodiments are not provided with any gate insulating layer 3.

The substrate 1 constituting these field effect transistors has flat surfaces and is formed of a material having a sufficient heat resistance and stable properties, and capable of allowing semiconductor films and insulating films to adhere thereto by a sufficient adhesion, such as quartz glass, alumina, borosilicate glass, barium borosilicate glass, c-Si, stainless steel, polyimide, Ta, Ni or Cr. However, in the pluralities of transistors shown in Figs. 4 to 6, when the source electrode 6 and the drain electrode 7 are formed at the side of the substrate 1, namely at the lower layer, the substrate 1 must be a plate formed of an insulating material or a plate formed of a conductive material and having a surface coated with an insulating film to ensure the insulating property of the layer between the source electrode 6 and the drain electrode 7.

The gate electrodes 2 are formed of various kinds of conductive metals. For example, they are generally Ni, Mg, Cr-Ag, Cr, Cr-Au, ITO, SnO₂, ZnO, stainless steel, n+-type Si or p+-type Si. When the substrate 1 is formed of a conductive material, the substrate 1 may serve also as the gate electrode 2. The gate insulating layer 3 in contact with the gate electrode 2 is preferable to be formed of an amorphous material film, etc. having a small charge density and a high insulation performance, such as SiOₓ, SiNₓ, SiOₓN_{y} or TiO₂. When the gate electrode 2 is formed of c-Si, a film of SiO₂ formed by thermal oxidation is used as the gate insulating layer 3. When the gate electrode 2 is formed of Ta or Ti, a film of TiO₂ or Ta₂O₅ formed by anodic oxidation or a composite film including such an insulating film is used as the gate insulating layer 3. The gate layer 2' of the junction field effect transistor is a film of a conductive material capable of forming a barrier with the first semiconductor layer 4. For example, a metal which forms a Schottky barrier with the first semiconductor layer 4, such as Ni, Cr or Aℓ, a semiconductor which forms a hetero junction with the first semiconductor layer 4, such as SnO₂, ITO or ZnO or a semiconductor which forms a pn junction with the first semiconductor layer 4, such as a p-type semiconductor or an n-type semiconductor, or a multilayer film of those semiconductors and conductive materials.

Generally, the first semiconductor layer 4, the second semiconductor layers 5a, 5b, the intermediate semiconductor layer 9 and the third semiconductor layer 10 are thin films, preferably, thin crystalline films or thin amorphous films, of Si, Ge, SiC, Se or Te, etc. Impurities doped to the second semiconductor layers 5a, 5b, the intermediate semiconductor layer 9 and the third semiconductor layer 10 for doping are selected taking into consideration the doping effect of the impurities in combination with the materials forming those layers. For example, P, B, Aℓ, As, Ga, Sb, etc. are suitable impurities for doping amorphous Si semiconductor layers and amorphous Ge semiconductor layers, and P, Cℓ and I are suitable impurities for doping amorphous semiconductor layers and amorphous Te semiconductor layers.

The source electrode 6 and the drain electrode 7 are formed of a conductive material capable of being in ohmic contact with the doped second semiconductor layers 5a, 5b. For example, generally, Ni, Mg, Cr-Ag, Cr, Cr-Au, ITO, SnO₂, ZnO, stainless steels, n+-type Si and p+-type Si are used for forming the source electrode 6 and the drain electrode 7.

For forming every layer of the thin film field effect transistor, there are variety of forming processes, the gate electrode 2, the source electrode 6 and the drain electrode 7 are formed, for example, by a vacuum evaporation process or a sputtering process. The gate insulating layer 3 is formed, for example, by a CVD process, a vacuum evaporation process, an anodic oxidation process or a thermal oxidation process. The first semiconductor layer 4 and the second semiconductor layers 5a, 5b are formed, for example, by the CVD process or the vacuum evaporation process. The component films of the thin film field effect transistors are patterned by a photolithographic process using a metal mask. The second semiconductor layers 5a, 5b are etched by an etching process capable of uniformly etching the second semiconductor layer 5 without damaging the underlying layer, such as a dry etching process or a wet etching process.

Concret examples according to the present invention will be described hereinafter together with examples helping in understanding the present invention.

### (Example 1)

As conceptionally shown in Fig. 1, a gate electrode 2 was formed by depositing Cr in a film of 30nm (300Å) of a glass substrate 1 by vacuum evaporation and patterning the Cr film. Then, an amorphous SiOₓ film of 135nm (1350Å) in thickness as a gate insulating layer 3 was formed on the substrate 1 provided with the gate electrode 2 by plasma CVD process. An amorphous i-Si:H film of 50nm (500Å) in thickness as a first semiconductor layer 4 was formed by a plasma CVD process over the gate insulating layer 3, and then an amorphous n+-Si:H film of 50nm (500Å) was formed as a doped second semiconductor layer 5 on the first semiconductor layer 4 by a plasma CVD process. A Cr film of 30nm (300Å) in thickness was formed as a source electrode 6 and a drain electrode 7 on the substrate 1 having the second semiconductor layer by a vacuum evaporation process using a mask. A channel of 200 µm in length and 6000 µm in width was formed between the source electrode 6 and the drain electrode 7.

Then, a middle portion of the second semiconductor layer between the portions 5a, 5b, namely, the portion of the second semiconductor layer 5 in contact with the channel 8 of the first semiconductor layer 4, was etched using the source electrode 6 and the drain electrode 7 as masks by a plasma etching process in a film thickness to be varied in the range of 0 to 50nm (500Å) to thereby form an intermediate semiconductor layer 9.

Then, the source electrode 6, the drain electrode 7 and the space therebetween were coated with a resist mask, and portions of the first semiconductor layer 4 and the second semiconductor layer 5 around the source and the drain electrodes 6, 7, which are not coated with the resist mask were removed by a plasma etching process.

Thus, thin film field effect transistors having a multilayer structure as shown in Fig. 1 and intermediate semiconductor layers 9 having different thicknesses as shown in Fig. 7 were fabricated.

Drain currents I_{d} for various levels of a drain voltage V_{d} and a gate voltage V_{g} of the thus fabricated thin film field effect transistors were measured by a measuring circuit as shown in Fig. 35. Measured results for those thin film FETs are shown in a graph of Fig. 36, in which a gate voltage V_{g} is measured on the horizontal axis, and dI_{d}/dV_{d}, namely, the derivative of I_{d} for the drain voltage V_{d} infinitely close to zero with respect to the drain voltage V_{d}, is measured on the vertical axis. According to the intercepts of the curves on horizontal axis, a gate threshold voltages Vₜₕ of the thin film field effect transistors can be obtained. Fig. 37 shows the relation between the gate threshold voltage Vₜₕ thus determined and the thickness of the intermediate semiconductor layer 9.

From the result of above-mentioned, it is known that the gate threshold voltage Vₜₕ varies in accordence with the thickness of the intermediate semiconductor layer 9. The variation of the gate threshold voltage Vₜₕ with respect to the thickness of the intermediate semiconductor layer 9 decreases when the thickness of the intermediate semiconductor layer 9 exceeds Xₘ expressed by:

${\text{X}}_{\text{m}} {\text{= {2εΔV/q · (N}}_{\text{DE}} {\text{+}}_{\text{NE}} {\text{)}}_{\text{}}} {\text{}}^{\text{1/2}}$

where ε is the dielectric constant of the semiconductor, Δ is the variation of the potential of the intermediate semiconductor layer 9, q is charge elementary quantity, N_{DE} is the concentration of active impurity in the intermediate semiconductor layer 9, and N_{E} is the equivalent charge level density of the intermediate semiconductor layer 9.

The gate threshold voltage Vₜₕ of a thin film field effect transistor not having the intermediate semiconductor layer 9, namely, the thin film field effect transistor in which a portion between the second semiconductor layers 5a, 5b formed of a doped amorphous n+-Si:H is removed completely by etching, was measured for comparison and shown in Fig. 37 in which a portion coresponding to the thickness 0 is circled.

### (Example 2)

A thin film field effect transistor was fabricated by processes similar to those employed in fabricating the thin film field effect transistor in the Example 1 excepting that a film of amorphous p+-Si:H of 50nm (500Å) in thickness formed by a plasma CVD was used as the doped second semiconductor layer instead of the amorphous film of n+-Si:H film of the second semiconductor layer.

The gate threshold voltage Vₜₕ of this transistor varies with respect to the thickness of the intermediate semiconductor layer 9 formed between the second semiconductor layers 5a and 5b along a curve reverse to the curve shown in Fig. 37.

### (Example 3)

As shown in Fig. 4, a Cr film of 30nm (300Å) in thickness was formed on a glass substrate 1 by vacuum evaporation, and then the Cr film was patterned to form source electrodes 6 and drain electrodes 7 each of 200 µm in channel length and 6000 µm in channel width.

An amorphous n+-Si:H film of 50nm (500Å) in thickness as a doped second semiconductor layer 5 was formed by a plasma CVD process on the substrate 1 having the source electrodes 6 and the drain electrodes 7. Portions of the second semiconductor layer 5 corresponding to the underlying source electrodes 6 and the drain electrodes 7 were coated by a first resist mask, and then only the middle portions of the second semiconductor layers 5a, 5b were etched by a plasma etching process to form intermediate semiconductor layers 9 having different film thicknesses to be varied in the range of 0 to 50nm (500Å). After removing all the resist mask, an amorphous i-Si:H film of 50nm (500Å) in thickness was formed thereon by a plasma CVD process as a first semiconductor layer 4. Only a portion of the amorphous semiconductor layer corresponding to the source electrodes 6, the drain electrodes 7 and the intermediate semiconductor layers 9 were coated by a resist mask and the amorphous n+-Si:H film and the amorphous i-Si:H film in the rest parts around those portions were removed, and then the resist mask was removed. Then, an amorphous SiOₓ film of 135nm (1350Å) in thickness as gate insulating layers 3 were formed by a plasma CVD process. Thereafter, and then a Cr film of 30nm (300Å) in thickness as the gate electrodes 2 were formed by vacuum evaporation using a mask. Thus plural thin film field effect transistors having the multilayer deposited structure shown in Fig. 4 and the respective intermediate semiconductor layers 9 having different thickness to be varied in the range of 0 to 50nm (500Å), respectively as shown in Fig. 10 are fabricated.

The characteristic of these transistors similar to those of Example 1 was obtained by the same test as made in the Example 1.

### (Example 4)

As shown in Fig. 13, when middle portions of the second semiconductor layers 5a, 5b formed of an n-type semiconductor in the Example 1 set forth above are etched, a part thereof is not remained but the portions in contact with channels 8 were removed completely to form amorphous p+-Si:H films respectively of thicknesses differentiated in the range of 0 to 50nm (500Å) as third semiconductor layers 10 respectively in those portions by a plasma CVD process using a metal mask, whereby portions of the third semiconductor layers 10 in contact with the channels 8 form intermediate semiconductor layers 9. Thin films field effect transistors have been fabricated, excepting set forth above, in the same way as illustrated in Fig. 13 and in the same manner as in Example 1.

A gate threshold voltage Vₜₕ of these transistors varies with respect to the thickness of the intermediate semiconductor layer 9 in contact with the channel 8 along a curve reverse to that shown in Fig. 37.

### (Example 5)

As shown in Fig. 15, when middle portions of the second semiconductor layers 5a, 5b formed of an n-type semiconductor in the Example 2 set forth above are etched, a part thereof is not remained but the portions in contact with channels 8 were removed completely to form amorphous p+-Si:H films respectively of thicknesses differentiated in the range of 0 to 50nm (500Å) as third semiconductor layers 10 respectively in those portions by a plasma CVD process using a metal mask, whereby portions of the third semiconductor layers 10 in contact with the channels 8 form intermediate semiconductor layers 9. Thin films field effect transistors have been fabricated, excepting set forth above, in the same way as illustrated in Fig. 15 and in the same manner as in Example 1.

A gate threshold voltage Vₜₕ of these transistors varies with respect to the thickness of the intermediate semiconductor layer 9 in contact with the channel 8 along a curve reverse to that shown in Fig. 37.

### (Example 6)

As shown in Fig. 13, when middle portions of the second semiconductor layers 5a, 5b formed of an n-type semiconductor in the Example 1 set forth above are etched, a part thereof is not remained but the portions in contact with channels 8 were removed completely to form amorphous n+-Si:H films respectively of thicknesses differentiated in the range of 0 to 50nm (500Å) as third semiconductor layers 10 respectively in those portions by a plasma CVD process using a metal mask, whereby portions of the third semiconductor layers 10 in contact with the channels 8 form intermediate semiconductor layers 9. Thin films field effect transistors have been fabricated, excepting set forth above, in the same way as illustrated in Fig. 13 and in the same manner as in Example 1.

The characteristic of these transistors similar to those of Example 1 was obtained by the same test as made in the Example 1.

### (Example 7)

As shown in Fig. 15, when middle portions of the second semiconductor layers 5a, 5b formed of an n-type semiconductor in the Example 2 set forth above are etched, a part thereof is not remained but the portions in contact with channels 8 were removed completely to form amorphous n+-Si:H films respectively of thicknesses differentiated in the range of 0 to 50nm (500Å) as third semiconductor layers 10 respectively in those portions by a plasma CVD process using a metal mask, whereby portions of the third semiconductor layers 10 in contact with the channels 8 form intermediate semiconductor layers 9. Thin films field effect transistors have been fabricated, excepting set forth above, in the same way as illustrated in Fig. 15 and in the same manner as in Example 1.

The characteristic of these transistors similar to those of Example 1 was obtained by the same test as made in the Example 1.

### (Example 8)

As shown in Fig. 14, amorphous p+-Si:H films respectively of thicknesses differentiated in the range of 0 to 50nm (500A) were formed on a glass substrate 1 by a plasma CVD process, and then the amorphous p+-Si:H films were patterned to form third semiconductor layers 10. A Cr film of 30nm (300Å) in thickness was formed on both sides thereof to form a source electrode 6 and a drain electrode 7. Then, the second semiconductor layers 5a, 5b of 200 µm in channel length and 6000 µm in channel width were formed by forming an amorphous n+-Si:H film of 50nm (500Å) in thickness by a plasma CVD process and patterning the amorphous n+-Si:H film.

Subsequently, first semiconductor layers 4, gate insulating layers 3 and gate electrodes 2 were formed in that order as same as those in the Example 3, for thereby fabricating the thin film field effect transistors as shown in Fig. 14.

A gate threshold voltage Vₜₕ of these transistors varies with respect to the thickness of the intermediate semiconductor layer 9 in contact with the channel 8 along a curve reverse to that shown in Fig. 37.

### (Example 9)

As shown in Fig. 14, amorphous p+-Si:H films respectively of thicknesses differentiated in the range of 0 to 50nm (500Å) were formed on a glass substrate 1 by a plasma CVD process, and then the amorphous p+-Si:H films were patterned to form third semiconductor layers 10. A Cr film of 30nm (300Å) in thickness was formed on both sides thereof to form a source electrode 6 and a drain electrode 7. Then, the second semiconductor layers 5a, 5b of 200 µm in channel length and 6000 µm in channel width were formed by forming an amorphous p+Si:H film of 50nm (500Å) in thickness by a plasma CVD process and patterning the amorphous p+-Si:H film.

Subsequently, first semiconductor layers 4, gate insulating layers 3 and gate electrodes 2 were formed in that order as same as those in the Example 3, for thereby fabricating the thin film field effect transistors as shown in Fig. 14.

A gate threshold voltage Vₜₕ of these transistors varies with respect to the thickness of the intermediate semiconductor layer 9 in contact with the channel 8 along a curve reverse to that shown in Fig. 37.

### (Example 10)

As shown in Fig. 16, amorphous p+-Si:H films respectively of thicknesses differentiated in the range of 0 to 50nm (500Å) were formed on a glass substrate 1 by a plasma CVD process, and then the amorphous p+-Si:H films were patterned to form third semiconductor layers 10. A Cr film of 30nm (300Å) in thickness was formed on both sides thereof to form a source electrode 6 and a drain electrode 7. Then, the second semiconductor layers 5a, 5b of 200 µm in channel length and 6000 µm in channel width were formed by forming an amorphous n+-Si:H film of 50nm (500Å) in thickness by a plasma CVD process and patterning the amorphous n+-Si:H film.

Subsequently, first semiconductor layers 4, gate insulating layers 3 and gate electrodes 2 were formed in that order as same as those in the Example 3, for thereby fabricating the thin film field effect transistors as shown in Fig. 16.

A characteristic of these transistors similar to those of Example 1 was obtained by the same test as made in the Example 1.

### (Example 11)

As shwon in Fig. 16, amorphous p+-Si:H films respectively of thicknesses differentiated in the range of 0 to 50nm (500Å) were formed on a glass substrate 1 by a plasma CVD process, and then the amorphous p+-Si:H films were patterned to form third semiconductor layers 10. A Cr film of 30nm (300Å) in thickness was formed on both sides thereof to form a source electrode 6 and a drain electrode 7. Then, the second semiconductor layers 5a, 5b of 200 µm in channel length and 6000 µm in channel width were formed by forming an amorphous p+Si:H film of 50nm (500Å) in thickness by a plasma CVD process and patterning the amorphous p+-Si:H film.

Subsequently, first semiconductor layers 4, gate insulating layers 3 and gate electrodes 2 were formed in that order as same as those in the Example 3, for thereby fabricating the thin film field effect transistors as shown in Fig. 14.

A characteristic of these transistors similar to those of Example 1 was obtained by the same test as made in the Example 1.

### (Example 12)

Thin film field effect transistors respectively having constructions as shown in Figs. 21 to 34 were fabricated, in which the gate insulating layers 3 of the thin film field effect transistors of Examples 1 to 11 were omitted, and gate layers 2' for forming a barrier were formed in contact with the first semicondutor layers 4, respectively.

A characteristic of the thin film field effect transistors of Example 12 as shown in Figs. 21 to 34 was similar to those of the thin film field effect transistors of Examples 1 to 11, respectively can be done by the similar test as made for the Example 1.

As explained above, thin film field effect transistors having different threshold voltage Vₜₕ can be fabricated by varying the thickness of the intermediate semiconductor layer 9 even if they are placed under the condition of using same thin film materials and same process of forming films. In manufacturing methods of the same, since the thin film field effect transistors respectively having a different gate threshold voltage Vₜₕ through control of the thickness of the intermediate semiconductor layer 9 or control of the thickness of the third semiconductor layers 10 can be fabricated with ease when those are formed, by means of etching process, hence an effect of easily fabricating the field effect transistors having different gate threshold voltage on the same substrate is obtained.

## Claims

1. A plurality of thin film field effect transistors formed on one substrate (1) comprising at least two thin film field effect transistors, each of them comprising:
a source electrode (6) and a drain electrode (7) separated from each other by a gap;
a first semiconductor layer (4) comprising a channel (8);
a second doped semiconductor layer (5a, 5b) comprising a first region (5a) formed between said source electrode (6) and said first layer (4) and comprising a second region (5b) formed between said drain electrode (7) and said first layer (4);
a third doped semiconductor layer (9) formed in contact with one surface of said first semiconductor layer (4) at said channel (8); and
a gate structure (2, 2', 3) connected to the other surface of said first semiconductor layer (4) at said channel (8);
said doped semiconductor layer (9) of said at least two transistors differing in their thicknesses thereby establishing different threshold voltages.

2. A plurality of thin film field effect transistors according to claim 1,
characterised in that
said gate structures consist of a gate electrode (2) and a gate insulating layer (3), said gate electrode (2) being capacity-coupled to said first semiconductor layer (4)

3. A plurality of thin film field effect transistors according to claim 1,
characterized in that
said gate structures consist of a gate layer (2') forming a barrier with said channel portion (8) on said other surface of said first semiconductor layer (4).

4. A plurality of thin film field effect transistors according to claim 2 or 3,
characterized in that
said third semiconductor layer (9) and said second semiconductor layer (5a, 5b) contain impurities giving the same type of conductivity.

5. A plurality of thin film field effect transistors according to claim 2 or 3,
characterized in that
said third semiconductor layer (9) and said second semiconductor layer (5a, 5b) contain impurities giving opposite types of conductivity.

6. A plurality of thin film field effect transistors according to any one of the claims 1 to 5,
characterized in that
said third semiconductor layer (9) is in contact with at least one of said regions (5a, 5b).

7. A plurality of thin film field effect transistors according to any one of the claims 1 to 5,
characterized in that
said third semiconductor layer (9) is not in contact with any of said regions (5a, 5b).

8. A method of manufacturing a plurality of thin film field effect transistors according to any of the preceding claims, comprising for each of the at least two transistors the steps of:
forming a source electrode (6) and a drain electrode (7) separated from each other by a gap;
forming a first semiconductor layer (4) comprising a channel (8);
forming a second doped semiconductor layer (5a, 5b) comprising a first region (5a) formed between said source electrode (6) and said first (4) and comprising a second region (5b) formed between said drain electrode (7) and said first layer (4);
forming a third doped semiconductor layer (9) in contact with one surface of said first semiconductor layer (4) at said channel (8); and
forming a gate structure (2, 2', 3) connected to the other surface of said first semiconductor layer (4) at said channel (8),
said doped semiconductor layers (9) of said at least two transistors differing in their thicknesses thereby establishing different threshold voltages.

9. A method of manufacturing according to claim 8,
characterized in that
said gate structures (2, 2', 3) are provided nearer to said substrate (1) than said first semiconductor layer (4).

10. A method of manufacturing according to claim 8,
characterized in that
said gate structures (2, 2', 3) are provided further from said substrate (1) than said first semiconductor layer (4).

11. A method of manufacturing according to claim 9 or 10,
characterized in that
said gate structures consist of a gate electrode (2) and a gate insulating layer (3), said gate electrode (2) being capacity-coupled to said first semiconductor layer (4).

12. A method of manufacturing according to claim 9 or 10,
characterized in that
said gate structures consist of a gate layer (2') forming a barrier with said channel portion (8) on said other surface of said first semiconductor layer (4).

13. A method of manufacturing according to claim 11 or 12,
characterized in that said third doped semiconductor layers (9) consist of.
a portion of said second doped semiconductor layers (5a, 5b) at the gap between said source electrode (6) and said drain electrode (7).

14. A method of manufacturing according to claim 13.
characterized in that
said portion of said second doped semiconductor layers (5a, 5b) is reduced in thickness by etching.

15. A method of manufacturing according to claim 13,
characterized in that said portion of said second doped semiconductor layers (5a, 5b) is reduced in thickness by oxidation of said portion.

16. A method of manufacturing according to claim 9,
further characterized by the following steps:
removing a portion of said second doped semiconductor layers (5a, 5b), at the gap between said source electrode (6) and said drain electrode (7); and forming there a fourth semiconductor layer (10), whereby said third doped semiconductor layers (9) are formed by at least a part of said fourth layer (10).

17. A method of manufacturing according to claim 10,
further characterized by the step of
forming a fourth semiconductor layer (10) on said substrate (1), whereby said third doped semiconductor layers (9) are formed by at least a part of said fourth layer (10).

## Patentansprüche

1. Mehrzahl von Dünnfilm-Feldeffekttransistoren, die auf einem Substrat (1) gebildet sind, und die wenigstens zwei Dünnfilm-Feldeffekttransistoren umfaßt, wobei jeder dieser versehen ist mit :
- einer Source-Elektrode (6) und einer Drain-Elektrode (7), die voneinander durch eine Lücke beabstandet sind,
- eine erste Halbleiterschicht (4) , mit einem Kanal (8),
- eine zweite dotierte Halbleiterschicht (5a, 5b) mit einer ersten Region (5a), die zwischender Source-Elektrode (6) und der ersten Schicht (4) gebildet ist und mit einer zweiten Region (5b), die zwischen der Drain-Elektrode (7) und der ersten Schicht (4) gebildet ist,
- einer dritten dotierten Halbleiterschicht (9), die in Kontakt mit einer Oberfläche der ersten Halbleiterschicht (4) an dem ersten Kanal (8) verbunden ist, und
- einer Gate-Struktur (2, 2' 3), die mit der anderen Fläche der ersten Halbleiterschicht (4) an dem Kanal (8) verbunden ist,
- wobei die dotierte Halbleiterschicht (9) der wenigstens zwei Transistoren sich in ihrer Dicke unterscheidet, wodurch verschiedene Schwellenspannungen erzeugt werden.

2. Mehrzahl von Dünnfilm-Feldeffekt-Transistoren nach Anspruch 1, dadurch gekennzeichnet, daß
die Gate-Strukturen aus einer Gate-Elektrode (2) und einer Gate-isolierenden Schicht (3) bestehen, wobei die Gate-Elektrode (2) mit der ersten Halbleiterschicht (4) kapazitiv gekoppelt ist.

3. Mehrzahl von Dünnfilm-Feldeffekt-Transistoren nach Anspruch 1, dadurch gekennzeichnet, daß
die Gate-Strukturen aus einer Gate-Schicht (2') bestehen, die zusammen mit dem Kanalabschnitt (8) einen auf der anderen Fläche der ersten Halbleiterschicht (4) eine Sperre bilden.

4. Mehrzahl von Dünnfilm-Feldeffekt-Transistoren nach Anspruch 2 oder 3, dadurch gekennzeichnet, daß
die dritte Leiterschicht (9) und die zweite Halbleiterschicht (5a, 5b) Unreinheiten enthalten, die den gleichen Leitungstyp ergeben.

5. Mehrzahl von Dünnfilm-Feldeffekt-Transistoren nach Anspruch 2 oder 3, dadurch gekennzeichnet, daß
die dritte Halbleiterschicht (9) und die zweite Halbleiterschicht (5a, 5b) Unreinheiten enthalten, die entgegengesetzten Leitungstypen ergeben.

6. Mehrzahl von Dünnfilm-Feldeffekt-Transitoren nach einem der vorangehenden Ansprüche 1 bis 5, dadurch gekennzeichnet, daß
die dritte Halbleiterschicht (9) in Kontakt mit wenigstens einer der Regionen (5a, 5b) ist.

7. Mehrzahl von Dünnfilm-Feldeffekt-Transistoren nach einem der Ansprüche 1 bis 5, dadurch gekennzeichnet, daß
die dritte Halbleiterschicht (9) nicht in Kontakt mit einer der Regionen (5a, 5b) ist.

8. Verfahren zum Herstellen einer Mehrzahl von Dünnfilm-Feldeffekt-Transistoren nach einem der vorangehenden Ansprüche, für jeden der wenigstens zwei Transistoren mit den Schritten :
- Bilden einer Source-Elektrode (6) und einer Drain-Elektrode (7), die voneinander durch eine Lücke beabstandet sind,
- Bilden einer ersten Halbleiterschicht (4), die einen Kanal (8) umfaßt,
- Bilden einer zweiten dotierten Halbleiterschicht (5a, 5b) mit einer ersten Region (5a) zwischen der Source-Elektrode (6) und der ersten Schicht (4) und mit einer zweiten Region (5b), die zwischen der Drain-Elektrode (7) und der ersten Schicht (4) gebildet ist;
- Bilden einer dritten dotierten Halbleiterschicht (9) in Kontakt mit einer Fläche der ersten Halbleiterschicht (4) an dem Kanal (8) und
- Bilden einer Gate-Struktur (2, 2', 3) in Verbindung mit der Außenfläche der ersten Halbleiterschicht (4) an dem Kanal (8),
wobei die dotierte Halbleiterschicht (9) der wenigstens zwei Transistoren sich in ihrer Dicke unterscheidet, wodurch verschiedene Schwellspannungen erzeugt sind.

9. Verfahren zum Herstellen nach Anspruch 8, dadurch gekennzeichnet, daß
die Gate-Strukturen (2, 2', 3) näher an dem Substrat (1) angeordnet werden, als die erste Halbleiterschicht (4).

10. Verfahren zum Herstellen nach Anspruch 8, dadurch gekennzeichnet, daß
die Gate-Strukturen (2, 2', 3) von dem Substrat (1) weiter entfernt als die erste Halbleiterschicht (4) angeordnet werden.

11. Verfahren zum Herstellen nach Anspruch 9 oder 10, dadurch gekennzeichnet, daß
die Gate-Strukturen aus einer Gate-Elektrode (2) und einer Gate-isolierenden Schicht (3) bestehen, wobei die Gate-Elektrode (2) kapazitiv mit der ersten Halbleiterschicht (4) gekoppelt ist.

12. Verfahren zum Herstellen nach Anspruch 9 oder 10, dadurch gekennzeichnet, daß
die Gate-Struktur aus einer Gate-Schicht (2') besteht, die eine Barriere mit dem ersten Kanalabschnitt (8) auf der anderen Seite der ersten Halbleiterschicht (4) bildet.

13. Verfahren zum Herstellen nach Anspruch 11 oder 12, dadurch gekennzeichnet, daß
die dritten dotierten Halbleiterschichten (9) aus einem Abschnitt der zweiten dotierten Halbleiterschichten (5a, 5b) an der Lücke zwischen der Source-Elektrode (6) und der Drain-Elektrode (7) bestehen.

14. Verfahren zum Herstellen nach Anspruch 13, dadurch gekennzeichnet, daß
der Abschnitt der zweiten dotierten Halbleiterschichten (5a, 5b) in der Dicke durch Ätzen verringert ist.

15. Verfahren zum Herstellen nach Anspruch 13, dadurch gekennzeichnet, daß
der Abschnitt der zweiten dotierten Halbleiterschichten (5a, 5b) in der Dicke durch Oxidation des Abschnittes verringert ist.

16. Verfahren zum Herstellen nach Anspruch 9, weiter durch die folgenden Schritte gekennzeichnet:
- Entfernen eines Abschnittes der zweiten dotierten Halbleiterschichten (5a, 5b) an der Lücke der Source-Elektrode (6) und der Drain-Elektrode (7) und
- Bilden einer vierten Halbleiterschicht (10) an diesem Ort, wodurch die dritten dotierten Halbleiterschichten (9) wenigstens von einem Teil der vierten Halbleiterschicht (10) gebildet werden.

17. Verfahren zum Herstellen nach Anspruch 10, weiter gekennzeichnet durch den Schritt des
Bildens einer vierten Halbleiterschicht (10) auf dem Substrat (1), wodurch die dritten dotierte Halbleiterschichten (9) durch wenigstens einen Teil der vierten Halbleiterschicht (10) gebildet werden.

## Revendications

1. Pluralité de transistors à effet de champ à couches minces formée sur un substrat (1), comprenant au moins deux transistors à effet de champ à couches minces, chacun d'entre eux comprenant :
une électrode de source (6) et une électrode de drain (7) séparées entre elles par un interstice;
une première couche à semiconducteur (4) comportant un canal (8);
une deuxième couche à semiconducteur dopé (5a, 5b), comprenant une première zone (5a) formée entre ladite électrode de source (6) et ladite première couche (4) et une seconde zone (5b) formée entre ladite électrode de drain (7) et ladite première couche (4);
une troisième couche à semiconducteur dopé (9), formée en contact avec une surface de ladite première couche à semiconducteur (4) par ledit canal (8); et
une structure de grille (2, 2'; 3) reliée à l'autre surface de ladite première couche à semiconducteur (4) par ledit canal (8);
lesdites couches à semiconducteur dopé (9) desdits au moins deux transistors présentant des épaisseurs différentes, de manière à établir des tensions de seuil différentes.

2. Pluralité de transistors à effet de champ à couches minces selon la revendication 1,
caractérisée en ce que lesdites structures de grille consistent en une électrode de grille (2) et une couche d'isolation de grille (3), ladite électrode de grille (2) étant couplée par capacité à ladite première couche à semiconducteur (4).

3. Pluralité de transistors à effet de champ à couches minces selon la revendication 1,
caractérisée en ce que lesdites structures de grille consistent en une couche de grille (2') formant une barrière avec ladite partie formant canal (8), sur ladite autre surface de ladite première couche à semiconducteur (4).

4. Pluralité de transistors à effet de champ à couches minces selon la revendication 2 ou 3,
caractérisée en ce que ladite troisième couche à semiconducteur (9) et ladite deuxième couche à semiconducteur (5a, 5b) contiennent des impuretés donnant lieu au même type de conductivité.

5. Pluralité de transistors à effet de champ à couches minces selon la revendication 2 ou 3,
caractérisée en ce que ladite troisième couche à semiconducteur (9) et ladite deuxième couche à semiconducteur (5a, 5b) contiennent des impuretés donnant lieu à des types de conductivité opposes.

6. Pluralité de transistors à effet de champ à couches minces selon l'une quelconque des revendications 1 à 5,
caractérisée en ce que ladite troisième couche à semiconducteur (9) est en contact avec au moins l'une desdites zones (5a, 5b).

7. Pluralité de transistors à effet de champ à couches minces selon l'une quelconque des revendications 1 à 5,
caractérisée en ce que ladite troisième couche à semiconducteur (9) n'est en contact avec aucune desdites zones (5a, 5b).

8. Procédé de fabrication d'une pluralité de transistors à effet de champ à couches minces selon l'une quelconque des revendications précédentes, comprenant, pour chacun des au moins deux transistors, les étapes de :
formation d'une électrode de source (6) et d'une électrode de drain (7) séparées entre elles par un interstice,
formation d'une première couche à semiconducteur (4) comprenant un canal (8),
formation d'une deuxième couche à semiconducteur dopé (5a, 5b) comprenant une première zone (5a) formée entre ladite électrode de source (6) et ladite première couche (4) et comprenant une seconde zone (5b) formée entre ladite électrode de drain (7) et ladite première couche (4),
formation d'une troisième couche à semiconducteur (9) en contact avec une surface de ladite première couche à semiconducteur (4) au niveau dudit canal (8);
formation d'une structure de grille (2, 2'; 3) reliée à l'autre surface de ladite première couche à semiconducteur (4) au niveau dudit canal (8);
lesdites couches à semiconducteur dopé (9) desdits au moins deux transistors présentant des épaisseurs différentes, de manière à établir des tensions de seuil différentes.

9. Procédé de fabrication selon la revendication 8,
caractérisé en ce que lesdites structures de grille (2, 2'; 3) sont prévues plus proches dudit substrat (1) que ne l'est ladite première couche à semiconducteur (4).

10. Procédé de fabrication selon la revendication 8,
caractérisé en ce que lesdites structures de grille (2, 2'; 3) sont prévues plus loin dudit substrat (1) que ne l'est ladite première couche à semiconducteur (4).

11. Procédé de fabrication selon la revendication 9 ou 10,
caractérisé en ce que lesdites structures de grille consistent en une électrode de grille (2) et une couche d'isolation de grille (3), ladite électrode de grille (2) étant couplée par capacité à ladite première couche à semiconducteur (4).

12. Procédé de fabrication selon la revendication 9 ou 10,
caractérisé en ce que lesdites structures de grille consistent en une première couche de grille (2') formant une barrière avec ladite partie formant canal (8) sur ladite autre surface de ladite première couche à semiconducteur (4).

13. Procédé de fabrication selon la revendication 11 ou 12,
caractérisé en ce que lesdites troisièmes couches à semiconducteur dopé (9) consistent en une partie de ladite deuxième couche à semiconducteur dopé (5a, 5b), au niveau de l'interstice entre ladite électrode de source (6) et de ladite électrode de drain (7).

14. Procédé de fabrication selon la revendication 13,
caractérisé en ce que l'épaisseur de ladite partie desdites deuxièmes couches à semiconducteur dopé (5a, 5b) est réduite par gravure chimique.

15. Procédé de fabrication selon la revendication 13,
caractérisé en ce que l'épaisseur de ladite partie desdites deuxièmes couches à semiconducteur dopé (5a, 5b) est réduite par oxydation de ladite partie.

16. Procédé de fabrication selon la revendication 9, caractérisé en outre par les étapes qui suivent :
élimination d'une partie desdites deuxièmes couches à semiconducteur dopé (5a, 5b), au niveau de l'interstice entre ladite électrode de source (6) et ladite électrode de drain (7) et, ensuite, formation à cet endroit d'une quatrième couche à semiconducteur (10), de manière que lesdites troisièmes couches à semiconducteur dopé (9) soient formées par au moins une partie de ladite quatrième couche (10).

17. Procédé de fabrication selon la revendication 10, caractérisé en outre par l'étape de :
formation d'une quatrième couche à semiconducteur (10) sur ledit substrat (1), de manière que lesdites troisièmes couches à semiconducteur dopé (9) soient formées par au moins une partie de ladite quatrième couche (10).
